# EUROPEAN PATENT SPECIFICATION

(11) **EP 2 541 415 B1**
(45) Date of publication and mention of the grant of the patent: **01.01.2014**
(21) Application number: 11172202.1
(22) Date of filing: 30.06.2011
(51) Int. Cl.: G06F 11/267, G01R 31/3185

(54) **Fault mode circuits**
Fehlermodusschaltungen
Circuits de mode de défaillance

(43) Date of publication of application: 02.01.2013
(73) Proprietor: IMEC, 3001 Leuven (BE)
(72) Inventor: Badaroglu, Mustafa, 3010 Kessel-Lo (BE); Marinissen, Erik Jan, 3001 Leuven (BE); Marchal, Paul, 3052 Blanden (BE)
(74) Representative: Mackett, Margaret Dawn

(56) References cited:
- EP-A1- 2 372 379
- EP-A2- 1 431 771
- US-A1- 2003 025 516
- US-A1- 2004 186 675
- US-A1- 2006 195 749
- US-A1- 2008 243 740
- US-A1- 2009 212 760
- US-A1- 2011 012 633

## Description

### Field of the Invention

The present invention relates to fault mode circuits and is more particularly, although not exclusively, concerned with full screening of through-silicon-via connections on three-dimensional integrated circuits.

### Background to the Invention

The importance of testing integrated circuits (ICs) is well known and several methods have been used for carrying out such testing. US-A-2009/0224784 describes a method in which a frequency-division multiplexing scheme of test signals is used for reducing the number of input/output contact pads that need to be connected to the semiconductor wafer on which the IC is formed.

US-B-7863106 describes a test fixture for testing wafers in which a test probe assembly provides connectivity to filled-through vias (FTVs) and a conductive glass handler is biased with an appropriate voltage for test. The test probe assembly measures the voltage drop from a top surface bond pad to a FTV to provide an indication of the integrity of the FTV. The test fixture also determines leakage resistance using an opens shorts test.

Built-in-self test (BIST) logic may be included in a three-dimensional (3D) stacked processor chip as described in US-A-2010/0185410. The BIST can test the entire assembled stacked processor chip and/or specific layers in the stack and/or components located on a specific layer. An integrated distributed test interface is built into each later so that all the layers can be tested at the same time.

It is known to check the integrity of through-silicon-via (TSV) connections in three-dimensional (3D) integrated circuits (ICs) and long tracks in mixed-signal ICs. One such apparatus and method is described in US-A-2010/0332177. A test access control apparatus and method for stacked chip devices that can perform system on chip (SOC) test and through-silicon-via (TSV) verification are disclosed. The apparatus includes test access mechanism (TAM) buses and an extended IEEE 1149.1 test access port (TAP) controller connected to the TAM buses. The TAM buses support controls of a memory built-in-self-test (BIST) circuit for memory known-good-die (KGD) tests that are carried out before the chip devices are stacked, and TSV chains for conducting TSV tests that verify any defect appearing in vertical interconnection in the stacked chip devices.

US-A-2010/0153043 also discloses monitoring apparatus for TSVs in a 3D IC. The TSVs are connected in a circuit with a plurality of inverters. A control signal is applied to the circuit to cause it to oscillate. An output signal with an oscillatory wave is generated and the frequency thereof is compared to an output signal obtained from an ideal-manufactured 3D IC having the same configuration to determine if the 3D IC being tested meets pre-defined parameters.

In US-A-2010/0013512, a method of testing TSVs is described. TSV stacks are selected to which a reference voltage source, a current source and a voltage measuring device is connected. Measurement of a voltage drop provides a relative estimation of the resistance of the TSV stack. Comparisons of the estimated resistance for each TSV stack enables the best TSV stacks to be selected for use.

US-A-2006/0195749 discloses an integrated circuit and a method of automatic calibration control of pin electronics using automatic test equipment. A calibration circuit is dedicated to a single channel of the automatic test equipment for a single pin of a device under test. The calibration cuircuit includes a state machine capable of determining calibration parameters including offset and gain which are applied to each sub-circuit of the pin electronics.

Existing tests for testing TSV connections and long tracks have implementation issues. For example, there may be difficulties with probing dense TSVs individually during wafer-sort and final test processes. It is important to sort good dies from bad dies before moving onto the stacking and/or assembly stages which are relatively expensive processes. The problems associated with sorting of dies include: the inability to probe the integrity of floating TSVs on both thinned and un-thinned wafers due to missing connections; the limitation imposed the electrical tests that need to be carried out at by the requirement to handle very fragile thinned wafers during wafer-sort tests; and the limitation to static logic tests for continuity checks of the connections between tiers as it is not possible the test the quality of the contact.

In addition, it is important to detect misalignment of dies and/or wafers during the stacking process. As this forms the last step before the assembly of the stacked tiers in the final package, detecting a fault at this stage saves the expensive packaging costs. Moreover, it is necessary to detect faults that arise from long wiring between digital and analogue elements of the wafer. Most of the long tracks are prone to bridging errors which can be hard to detect via bridging tests, especially for the interfaces between analogue and digital modes. In such tests, the same track needs to be repeated for the return track to ensure that the signal has been received at its destination correctly. This adds a lot of cost as well as signal integrity issues in these mixed-mode systems.

Existing test structures have severe limitations, for example, the requirement for large silicon area to implement test circuits when used over a large number of TSVs; the need for special analogue process options; limitation to test TSVs that carry digital signals but also analogue signals; the inability to generate a meaningful test output signal that represents the integrity of TSVs; the limitation to characterisation exercises on dedicated test circuits (the difficulty of integration into standard equipment or products); the imposition of large loading that limits the performance of the tier-to-tier communication; the lack of calibration of the measurements for each TSV for setting reliable limits for production tests, and the requirement for long test times over a large number of TSVs.

### Summary of the Invention

It is therefore an object of the present invention to provide a fault mode test method that does not suffer from the problems mentioned above.

It is another object of the present invention to provide a test circuit for carrying out the fault mode test method.

In accordance with a first aspect of the present invention, there is provided a method for performing at least one fault mode test on at least one of a plurality of through-silicon-via connections arranged on a substrate in an integrated circuit, the method comprising the steps of:-
a) selecting a through-silicon-via connection to be tested from said plurality of through-silicon-via connections;
b) selecting a calibration mode for the selected through-silicon-via connection by activating at least one switch in a path connecting the selected through-silicon-via connection to a calibration current path;
c) determining a calibration current measurement for the selected through-silicon-via connections;
d) selecting a measurement mode for the selected through-silicon-via connection by activating at least one switch in a path connecting the selected through-silicon-via connection to a test current path;
e) determining a measurement current for the selected through-silicon-via connection;
f) determining an actual measurement current by comparing the determined calibration current measurement and the determined measurement current in order to cancel out the effects of the resistance of the switches; and
g) comparing the actual measurement current to a threshold in accordance with a screening condition for the selected through-silicon-via connection.

The method of fault mode testing of TSVs in accordance with the present invention has improved performance over known methods. It is independent of the architecture of the substrate being tested and all that is required is the ability to connect to each element on the substrate that is to be tested.

Using the method of the present invention, it is possible to test digital mode, analogue mode and mixed mode elements on the substrate. As a calibration mode is used as part of the testing method, the circuit size required for the test circuit can be reduced, for example, in terms of the silicon resources.

In one embodiment, said at least one fault mode test comprises a leakage test between the selected through-silicon-via connection and the substrate.

In another embodiment, said at least one fault mode test comprises a short test between the selected through-silicon-via connection and at least one other through-silicon-via connection in close proximity to the selected through-silicon-via connection. Preferably, steps b) and c) are repeated for said at least one other through-silicon-via connection and step f) comprises using the calibration measurements for the selected through-silicon-via connection and said at least one other through-silicon-via connection.

In a further embodiment, said at least one fault mode test comprises a connection test between the selected through-silicon-via connection and another tier of the integrated circuit.

In accordance with another aspect of the present invention, there is provided an on-chip test circuit for performing at least one fault mode test, according to the method of the present invention, on at least one through-silicon-via connection in an integrated circuit, the circuit comprising:-
a power supply;
a calibration current path connectable to ground and to said at least one through-silicon-via connection;
a short current path connectable to ground and to said at least one through-silicon-via connection;
a test current path connected to the power supply and to said at least one through-silicon-via connection;
a plurality of switches for connecting said at least one through-silicon-via connection to at least one of the calibration current path, the short current path and the test current path; and
a controller for selecting said at least one through-silicon-via connection to be tested and for enabling at least one switch in accordance with said at least one fault mode test.

The test circuit of the present invention operates only on direct current, so alternating current components that may create interference with the testing process can be avoided.

Preferably, the on-chip test circuit further comprises a pull-up resistor connected to the measurement current path for providing current measurements in accordance with said at least one fault mode test. The pull-up resistor may either be on-chip or off-chip, that is, forming part of the integrated circuit or forming part of the test circuit.

Additionally, the on-chip test circuit preferably further comprises first and second pull-down resistors connected between respective ones of the calibration current path and the short current path and ground.

The test circuit is particularly useful where said at least one through-silicon-via is formed on at least one tier of the integrated circuit. In one embodiment, the integrated circuit comprises a plurality of tiers.

Advantageously, the present invention can avoid the use of wafer probes on TSVs to check their integrity as the TSVs are not probed directly. Additionally, the method of the present invention can be used to screen all phases of the stacking and/or assembly process in 3D thereby reducing the costs by ordering the tests in each phase of the assembly process.

With the method of the present invention, it is possible to set reliable (stable) production test limits for all TSVs due to the result of calibration for each TSV. Moreover, there can be less area overhead as well as no performance degradation after the integration of monitor circuits. There is no need for special process options, for example, capacitance, resistance etc., where the testing circuit is based on field effect transistors (FETs) in a low cost process.

Run-time monitoring of TSVs allows access to reliability and/or aging faults during the application and allows for correction before the fault occurs. Additionally, an improvement in yield can be obtained by re-routing of signals once a fault is detected in a TSV.

It is possible to integrate the method of the present invention anywhere in the die and does not need to be close to the actual TSV under test. This is particularly the case in DC-level current-mode operation, where there is no dependence on the RC values of wiring from TSVs to the monitoring circuit.

### Brief Description of the Drawings

For a better understanding of the present invention, reference will now be made, by way of example only, to the accompanying drawings in which:-
Figure 1 illustrates a schematic diagram of TSV testing;
Figures 2 to 5 illustrate respectively the stages at which TSV testing is carried out in accordance with the present invention;
Figure 6 illustrates design-for-test (DFT) architecture for a single tier in accordance with the present invention;
Figure 7 illustrates DFT architecture for three tiers in a three-dimensional stack in accordance with the present invention;
Figure 8 illustrates a schematic circuit for leakage testing measurements in accordance with the present invention;
Figure 9 is similar to Figure 8 but illustrates resistance calibration measurements in accordance with the present invention;
Figure 10 is similar to Figure 8 but illustrates TSV-to-TSV short fault measurement in accordance with the present invention;
Figure 11 is similar to Figure 8 but illustrates tier-to-tier connection fault measurements;
Figure 12 illustrates a flow chart for fault measurements;
Figure 13 illustrates a flow chart for short circuit measurements; and
Figure 14 illustrates a flow chart for connection measurements between tiers.

### Detailed Description of the Invention

The present invention will be described with respect to particular embodiments and with reference to certain drawings but the invention is not limited thereto. The drawings described are only schematic and are non-limiting. In the drawings, the size of some of the elements may be exaggerated and not drawn on scale for illustrative purposes.

Boundary-scan technologies are widely used for testing the integrity of ICs. All the pins (TSVs and/or functional input/output (I/O) pads) that connect to electronic logic are linked together in a set known as the boundary scan chain. JTAG (Joint Test Action Group (JTAG) is the common name for the IEEE standard IEEE 1149.1, standard test access port and boundary-scan architecture) is used to manipulate the external interface of the scan chain to test for certain faults, the external interface being input and output connections to other chips. In addition, JTAG can also be used to manipulate internal interfaces to test combinational logic, the internal interface being connections to on-chip registers etc. In both cases, testing is done with the IC after it has been mounted on the circuit board and sometimes whilst the board forms part of an operational system. When combined with BIST, the JTAG scan chain provides a solution for testing certain static faults. Control of scan chain is not limited to JTAG but it could also be done by another serial communication scheme.

Fault mode testing in accordance with the present invention can be implemented at any part of the assembly where fault screening would be performed, for example, in power ground configurations, wafer sort, thinning, redistribution layer (RDL) and stacking, as well as assembly. The test system is compact so that only uses minimum size switches are used in accordance with complementary metal-oxide-semiconductor (CMOS) technology.

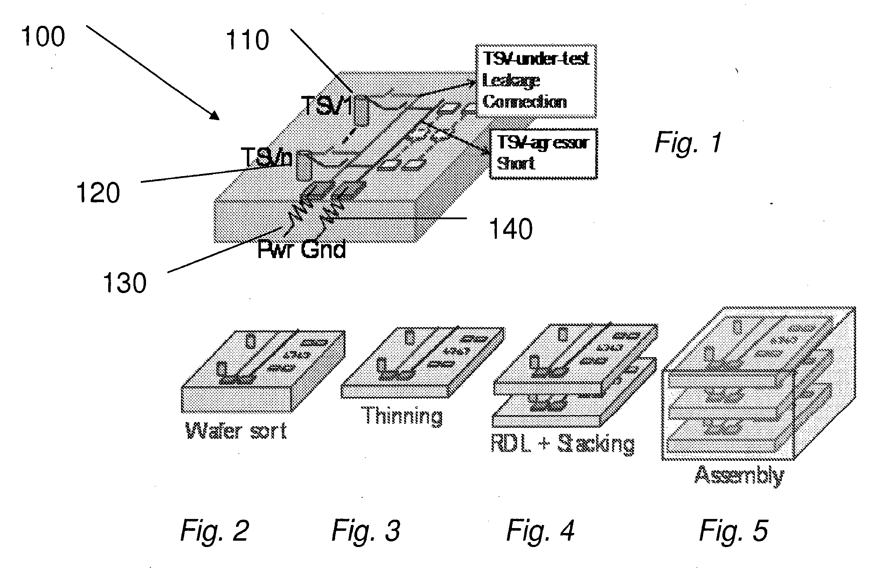

In Figure 1, a wafer 100 is shown that has a plurality of TSV element located thereon arranged in an array, but only TSV elements 110 (TSV1) and 120 (TSVn) are shown for clarity. The wafer also has a power line 130 and a connection to ground 140 as shown. Also shown is a leakage connection for TSV-under-test and a short circuit between TSVs. In the latter case, when testing each TSV for the presence of a short with any other TSV, the relationship of the other TSV to the TSV-under-test is described as TSV-aggressor.

The testing arrangement in accordance with the present invention is compact as the size of the switches are minimised due to the CMOS technology used and there is no overhead in performance and power in a functional mode. For each wafer, two extra signals are required, one for connection to a clock (re-routed to the JTAG clock, TCK, not shown) and one for connection to a flip-flop (also not shown). The testing operation will be described in more detail below.

Figures 2 to 5 illustrate the various stages at which TSV testing can be carried out. Testing for shorts and leakages can be carried out at wafer sort for full thickness wafers (Figure 2) and after wafer thinning (Figure 3). Testing after thinning detects wafers that may have been damaged during the thinning process or those which were marginal on the wafer sort and the faults have subsequently been highlighted after the thinning process. Testing after RDL and wafer stacking (Figure 4) and assembly (Figure 5) detects, in addition to shorts and leakages, connection issues between each wafer in a stack.

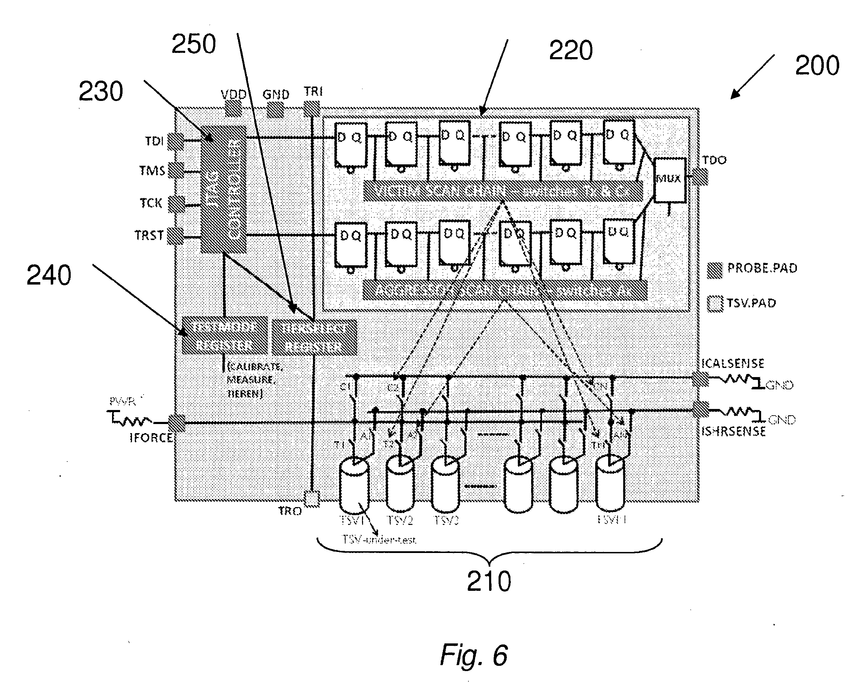

In Figure 6, the DFT architecture 200 is shown for a test network for a single tier or single wafer. The architecture can be programmed by means of any serial programming protocol. In this case, JTAG test protocol is used.

The architecture 200 comprises a plurality of TSVs 210 connected to an IFORCE pin, an ICALSENSE pin, and an ISHRSENSE pin as shown. Each TSV is connected to a victim scan chain and an aggressor scan chain by means of test switches Tx and calibration switches Cx (victim), and aggressor switches Ax (aggressor). As shown, TSV1 is connected by switches T1, C1 and A1, TSV2 is connected by switches T2, C2 and A2, ...., and TSVN is connected by switches TN, CN and AN. Ideally, the switches Tx, Cx and Ax are matched switches which are enabled/disabled by the operation of a configuration register 220 located in respective victim and aggressor scan chains, the connections between the configuration register 220 and the switches being indicated by dotted lined arrows.

A JTAG controller 230 is provided that is connected to the configuration register 220, a test mode register 240 and a tier select register 250. The controller 230 controls the test process for the TSVs 210. Inputs to the architecture 200 include a test clock pin (TCK), a test mode select input pin (TMS), and a test serial data input pin (TDI). The architecture 200 also includes a test serial data output pin (TDO). In addition, a test asynchronous reset pin (TRST), a power supply node or pin (VDD) and a ground node or pin (GND) are provided. Enable input and output with adjacent tiers are provided by input pin TRI and output pin TRO respectively.

It will be appreciated that although all the pins are shown individually, some of the pins could be shared. For example, the ICALSENSE pin, the ISHRSENSE pin and the GND node or pin could be shared with the ground pin of the chip, the VDD node or pin could be shared with the supply pin of the chip, and the TCK pin, TMS pin, TDI pin, TDO pin and TRST pin could be shared with the existing JTAG pins.

All connections are made with a probe pad (not shown) with the exception of the TRO pin, which is a TSV that handles the tier-to-tier communication.

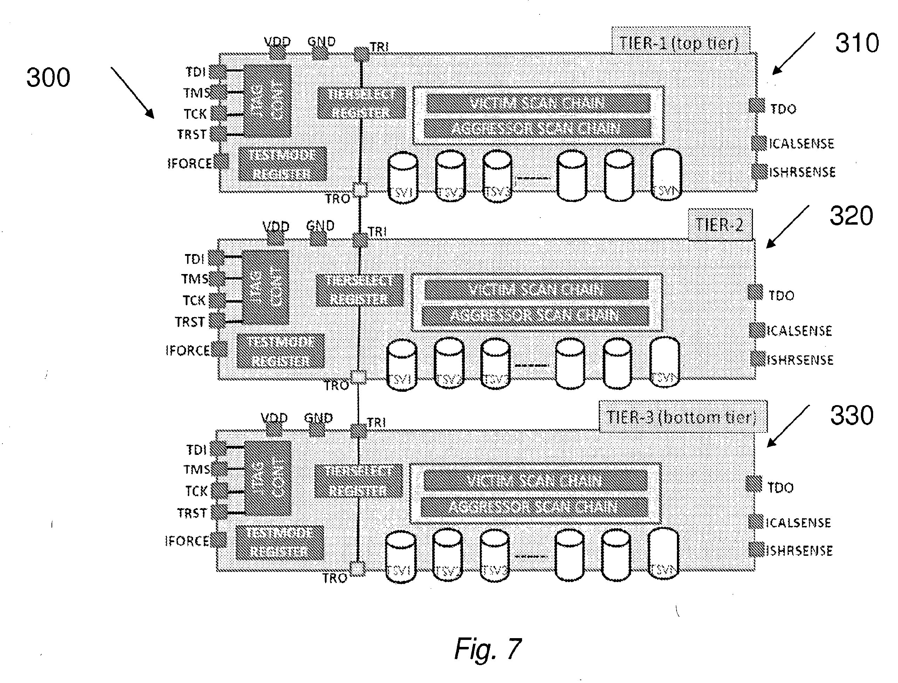

Figure 7 illustrates the architecture 300 for a three-tier testing system. Each tier 310, 320, 330 is identical to the single described with reference to Figure 6. The tiers 310, 320, 330 are connected for testing by means of the TRO pin from tier 310 connecting with the TRI pin for tier 320, and TRO pin from tier 320 connecting with TRI pin for tier 330. In this case, the tier-under-test is selected by a propagating a logic 'high' through the chained connections of the tier select registers.

Testing is based on monitoring a current coming from an external pull-up resistor towards the three current paths that are controlled by switches that are programmable using a serial programming bus, that is, the IEEE JTAG standard. The three current paths are as follows:
1. TSV-under-test current path (IFORCE)
2. Calibration current path (ICALSENSE)
3. TSV-to-TSV short current path (ISHRSENSE)

The tests are not limited to TSV-related faults but are also applicable to uBump related manufacturing faults.

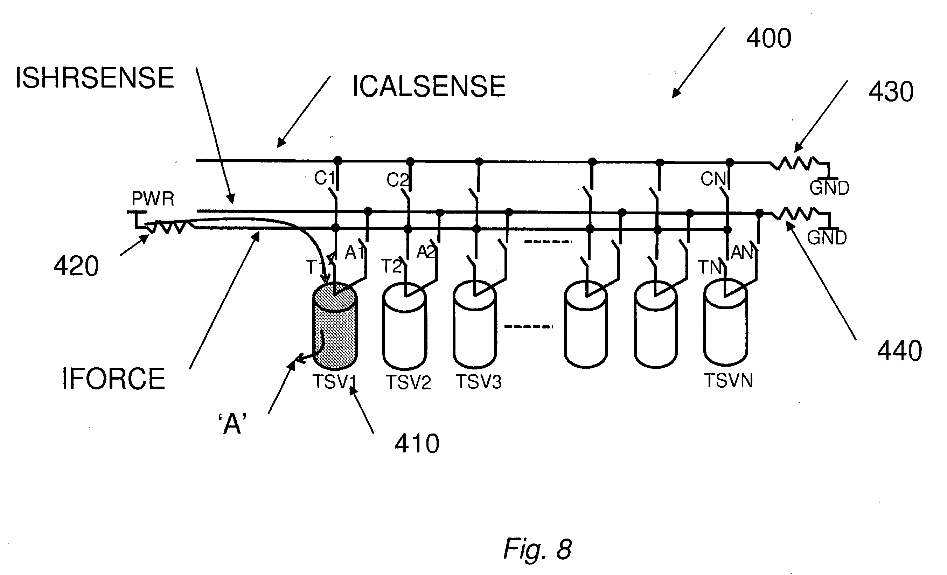

The following measurements are taken during different stages of the stacking/assembly process: substrate leakage measurements; calibration measurements; and TSV-to-TSV short measurements. Each of these measurements will be described with reference to Figures 8 to 10 below respectively.

In Figure 8, a schematic circuit 400 is shown for substrate leakage measurements. The ICALSENSE, ISHRSENSE, and IFORCE lines are shown. As described above, the ICALSENSE and ISHRSENSE lines are connected to ground and the IFORCE line is connected to a power supply. As shown in Figure 8, TSV1 is the TSV-under-test 410 and the TSV-under-test current path is defined as the path from the power supply, through a pull-up resistor 420, to TSV1 410. The pull-up resistor 420 has a value of a few kohms (e.g. 2-3 kΩ) and may be formed either as part of the integrated circuit being tested or as part of the test circuit itself. As shown, this current path is connected or enabled by means of the programmable test switch T1 operated by the flip-flops 220 (Figure 6). If there is any leakage from TSV1 410 to the substrate (not shown) as indicated by arrow 'A', the presence of a leakage current is monitored by measuring the current drawn from the pull-up resistor 420. Further pull-down resistors 430, 440 are also provided for connecting the ICALSENSE and ISHRSENSE lines to ground as shown. Each pull-down resistor 430, 440 has a value of a few kohms (e.g. 2-3 kΩ).

This test is repeated for each subsequent TSV, TSVN, by closing the associated switch, TN.

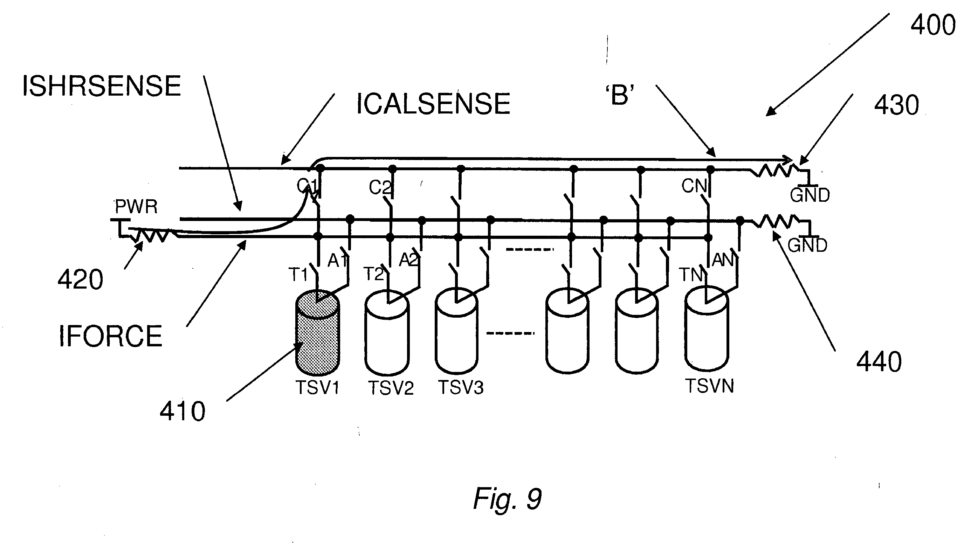

For calibration measurements, the same circuit 400 is used but in this case different switches are closed. In Figure 9, the ICALSENSE line is used for the calibration measurement. TSV1 is again the TSV-under-test as indicated by 410 but in this case, switch C1 is the one that is closed with T1 and A1 being open. The current path is from the power supply, through the pull-up resistor 420, and through switch C1 and along the ICALSENSE line to ground as indicated by arrow 'B'. Here, pull-up resistor 420 provides a calibration current instead of a leakage current.

As before calibration is repeated for each subsequent TSV, TSVN, by closing the associated switch, CN.

Calibration measurements are used to calibrate the resistance of the switches and the bus that are used to connect the TSV-under-test 410. The calibration current measurements (Figure 9) combined with the leakage current measurements (Figure 8) allow the resistance of possible leakage paths from each TSV to be determined so that accurate actual leakage current measurements to be calculated.

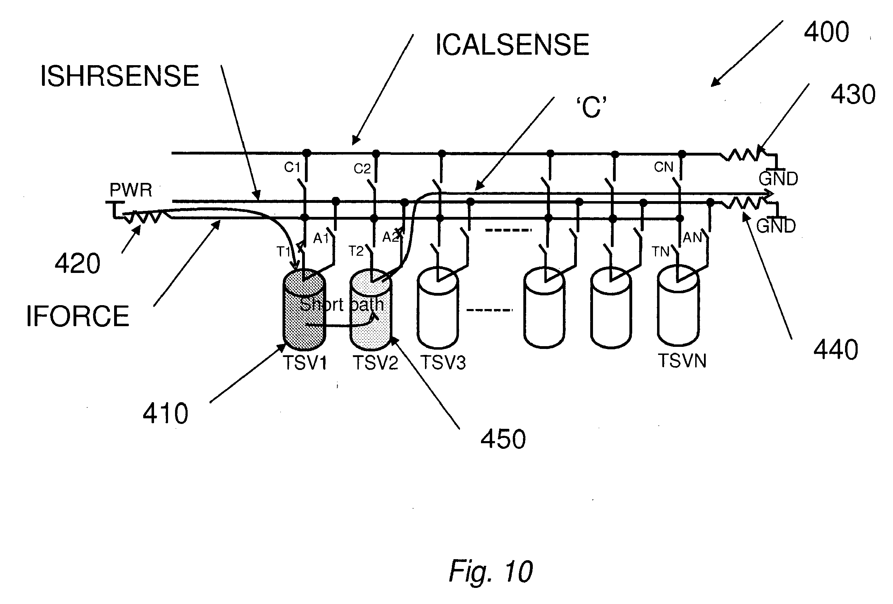

In Figure 10, the same circuit 400 shown in Figures 8 and 9 is used to determine TSV-to-TSV short measurements. As shown in Figure 10, the TSV-under-test 410 is tested for a short with respect to its adjacent TSV, TSV2 450. TSV2 450 is termed the TSV-aggressor. Here, switches T1 and A2 are closed so that, if there is a short between TSV1 410 and TSV2 450, the current path will be from the power supply, through switch T1 to TSV1 410, through TSV2, TSV450 to switch A2 and onto the ISHRSENSE line to ground as shown by arrow 'C'. By closing switch A2, the TSV-aggressor 450 is shorted to ground. The short current is measured in the pull-up resistor 410 instead of a leakage or calibration current as described above with reference to Figures 8 and 9 respectively.

Although TSV2 is shown as the TSV-aggressor, it will be appreciated that this process can be repeated for any other TSVN either separately or in combination with other TSVs.

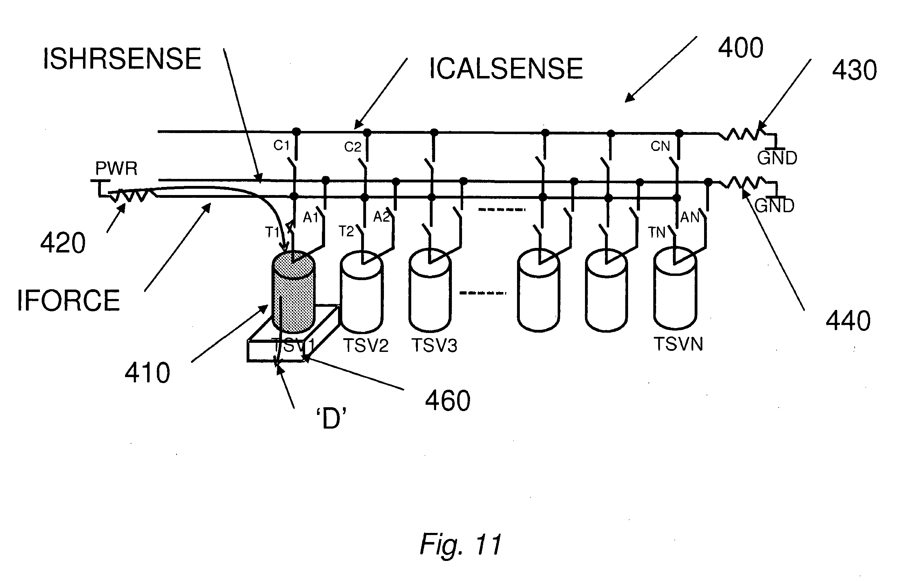

Tier-to-tier connection measurements can also be carried out as shown in Figure 11. The same circuit 400 is used again for checking the connection quality of TSV-to-metal of bottom tier. As before, switch T1 is closed so that a current flow path is provided from the power supply, through the switch T1 to the TSV 410 and through a metal wire 460 on the bottom tier. The metal wire must be pulled to a known potential, for example, to ground, for the current to flow, as indicated by arrow 'D', so that the measurement can be determined. In this case, the current measured at the pull-up resistor 420 is a connection current and not a leakage current.

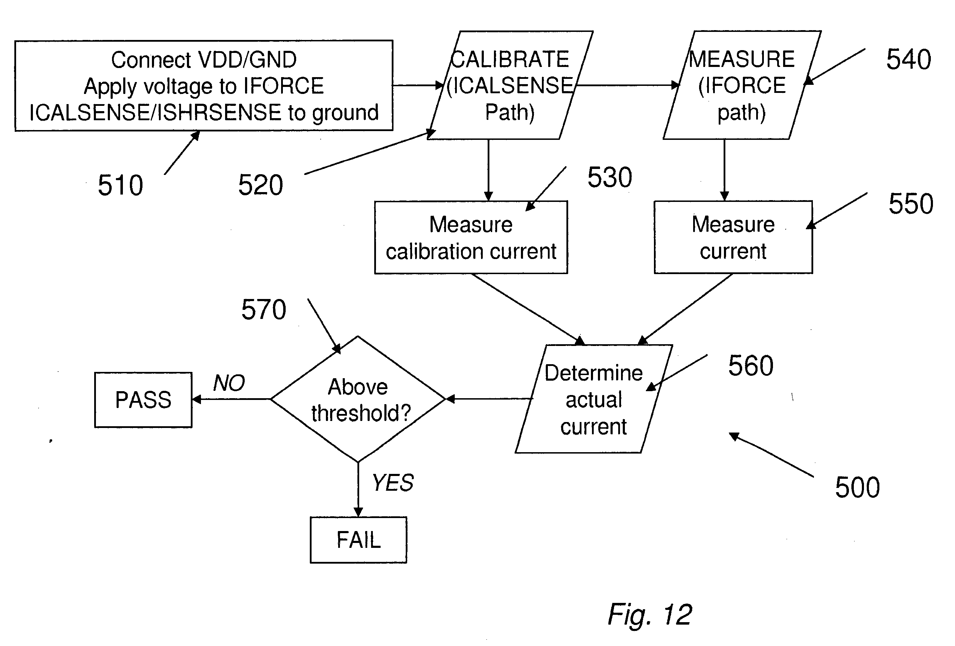

Methods for performing the fault tests will now be described with reference to Figures 12 to 14. Here, components which have previously been described in Figures 1 to 11 are referenced alike.

The method for measuring leakage during wafer-sort and wafer-thinning, as shown in Figures 2 and 3, will now be described with reference to Figure 12. It will be appreciated that, although the method will be described for TSV1, it is applicable to each and/or a plurality of all TSVN. Figure 12 illustrates a flow chart 500 in which the first step, step 510, is to connect power/ground connections to VDD/GND, apply a voltage to the IFORCE pin through the pull-up resistor 410, and connect ICALSENSE and ISHRSENSE pins to ground through pull-down resistors 430, 440. The TESTMODE register 240 is programmed to a "CALIBRATE" mode through the JTAG controller 230, and the TSV-under-test is selected through the JTAG controller 230 by shifting in a "logic-high" to the corresponding configuration register 220 (step 520). The calibration current leakage is measured through the ICALSENSE path as the current flowing through the pull-up resistor 420 (step 530). This measurement is then used to calibrate out the resistance of the switch C1 matched to the switch T1 in step 550 below.

Once the resistance values of the switches C1 and T1 have been determined, the TESTMODE register 240 is programmed to a "MEASURE" mode through the JTAG controller 230 (step 540), and the leakage current through the IFORCE path is determined by measuring the current drawn through the pull-up resistor 420 (step 550). In step 560, the leakage current determined in step 550 is then compared with the calibration current leakage determined in step 530 to cancel out the effects of the resistance of switches T1, C1 and A1, and to provide an actual current leakage. The actual current leakage is compared to a threshold in step 570 and if it is above a predetermined value, there is a faulty leakage from TSV1 to the substrate in which the TSV is mounted and the TSV-under-test is registered as a 'FAIL'. If the actual current is below the threshold, the TSV-under-test is registered as a 'PASS'.

As each TSV-under-test can be individually selected, it is possible to select all TSVs in configuration for measuring the overall leakage in an effort to reduce the test time.

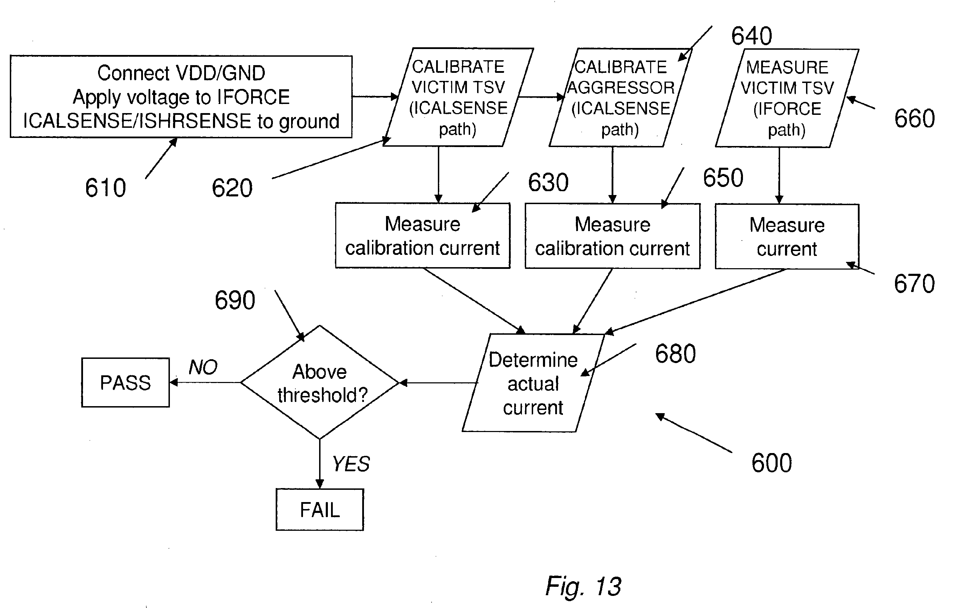

In Figure 13, the method for determining screening faults related to TSV-to-TSV shorts during wafer-sort and wafer-thinning is shown in flow chart 600. In step 610, the power and ground connections are made as described above, voltage is applied to the IFORCE pin through the pull-up resistor 420, the ICALSENSE and ISHRSENSE pins are connected to ground via the pull-down resistors 430, 440 as described above with reference to step 510 in Figure 12. The TESTMODE register 240 is programmed to the "CALIBRATE" mode through the JTAG controller 230 (step 620). This will then close the C1 switch once the TSV1 is selected as the TSV-under-test. The victim TSV, in this case, TSV1, is selected as the TSV-under-test through the JTAG interface by shifting in a "logic-high" to the corresponding configuration register 220. The leakage through the ICALSENSE path is measured by the pull-up resistor 420 (step 630) and is used to calibrate out the resistance of the switch C1 matched to the switch T1 in step 680 below.

Having selected the victim TSV as TSV1, the aggressor TSV, in this case, is selected as TSV2 (Figure 10) in step 640. It will be appreciated that any one of the other TSVs could also have been selected as the aggressor TSV. The selection is made by through the JTAG controller 230 by shifting in a "logic-high" to the corresponding configuration register 220. The current leakage through the ICALSENSE path is measured at the pull-up resistor 420 in step 650 and is used to calibrate out the resistance of the switch C2 matched to the switch A2 in step 680 below.

Once the calibration steps have been carried out, the TESTMODE register 240 is then programmed to "MEASURE" mode through the JTAG controller 230 in step 660. This closes switch T1. The aggressor TSV is selected as the TSV-shorting-pin through the JTAG controller 230 by shifting in "logic-high" to the corresponding configuration register 220. In this case, TSV2 is selected as the aggressor as shown n Figure 10. The leakage current is determined through the IFORCE path by measuring the current drawn through the pull-down resistor 420 in step 670. The leakage current obtained in step 670 is compared the calibration values obtained in steps 630 and 650 above to cancel out the resistance of switches T1 and A2 in step 680. The post-calibration current is compared to a threshold in step 690 and if the post-calibration current is above a predetermined limit, there is a short fault between TSV1 and TSV2 and TSV1 is considered as a 'FAIL'. If the post-calibration current is below the threshold, the TSV-under-test, TSV1, is considered as a 'PASS'.

It will be appreciated that, although the method above has been described with respect to the TSV-under-test being TSV1 and the aggressor TSV as being TSV2, the method for testing for short faults between TSVs can be carried out for any pair of TSVs in close proximity to one another, for example, TSVx for the victim and TSVy for the aggressor.

Test time for shorts will be reduced by selecting multiple aggressor TSVs in close proximity to the TSV-under-test to create a number of potential shorts therewith.

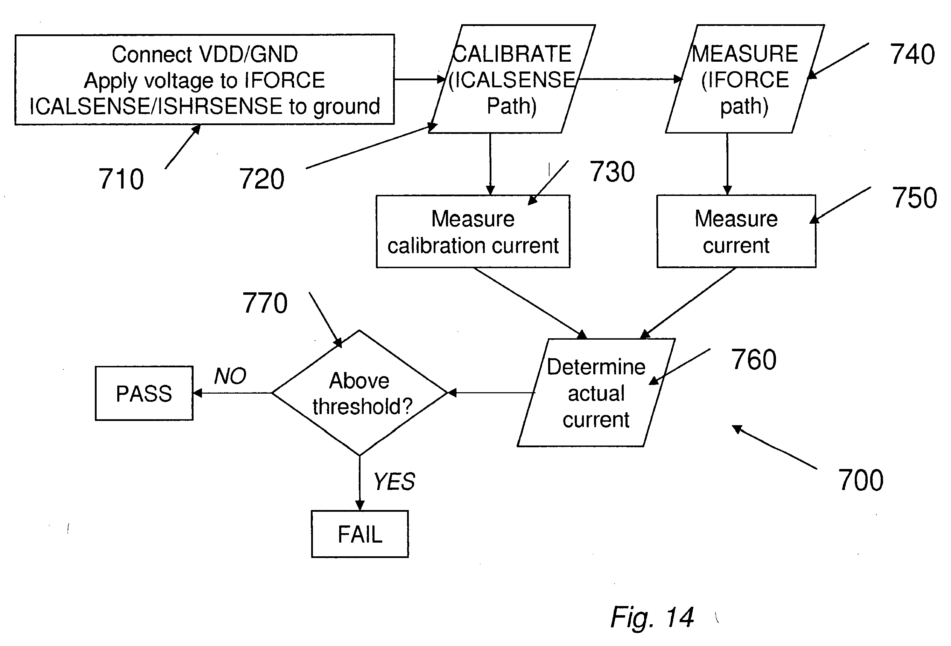

A flow chart 700 for measuring tier-to-tier connection faults after stacking, as described above with reference to Figures 4 and 5, is shown in Figure 14. In step 710, connections to VDD/GND are made, a voltage supply is connected to the IFORCE pin through the pull-up resistor 420, and the ICALSENSE and ISHRSENSE pins are connected to ground by means of the pull-down resistors 430, 440. A "logic-high" signal is supplied to the tier being tested via the TIERSELECT register chain 250 starting with the uppermost tier. The last tier is the one on top of the lowermost tier. All TSVs located below the selected tier is pulled-down to ground. In step 720, the TESTMODE register 240 is programmed to the "CALIBRATE" mode through the JTAG controller 230, and the TSV-under-test is selected through the JTAG controller 230 by shifting in "logic-high" to the corresponding configuration register 220. The leakage current through the ICALSENSE path is measured in step 730. This measurement will then be used calibrate out the resistance of the switch C1 matched to the switch T1 in step 790 below.

In step 740, the TESTMODE register 240 is programmed to the "MEASURE" mode through the JTAG controller 230, and the leakage current is measured through the IFORCE path by measuring the current drawn through the pull-up resistor 420 in step 750. In step 760, the current determined in step 730 is compared with the current determined in step 750 to calibrate out the resistance of switches and to provide an actual current value. The actual current value is compared to a threshold in step 760, and if above a predetermined value, there is a faulty connection from TSV1 to the bottom tier and the TSV1 is considered as a 'FAIL'. If the actual current is below the threshold, the TSV-under-test is considered as a 'PASS'. The steps are repeated for the next tier.

In a similar way, fault modes of long tracks between digital and analogue can be tested using the same set of circuits described above. This is done by measuring a potential leakage of the track itself if the track is terminated with a high-impedance (which is typical in case where the driver of a CMOS gate or the supply of driver on the analogue side is not connected) and by measuring a potential short with a neighbouring track which is also between digital to analogue.

The overhead of fault monitoring circuits is assessed in terms of silicon area overhead, interconnect overhead, and test time analysis and its optimisation using parallel measurements.

Silicon (active) area overhead of the unit circuit per TSV comprises: three NMOS switches that control the connection to the ICALSENSE, ISHRSENSE and the IFORCE current paths; combinational logic in the form of two AND gates, a NOR gate, an OR gate, two flip-flops and a multiplexor. The two flip-flops are provided for the two boundary-scans to select the TSV-under-test and the TSV-aggressor, and share the task of enabling the industry standard boundary scan tests across TSVs. The multiplexor is used to multiplex the output of the two boundary scans to the common serial output TDO.

The interconnect overhead for a chip that contains N TSVs comprises:
a) a configuration clock that is common for all of N TSVs - this is used for the boundary scan that selects the TSV-under-test;
b) a configuration clock that is common for all of N TSVs - this is used for the boundary scan that selects the TSV-aggressor.
c) a calibration enable that is common for all of N TSVs - this is used for calibrating the switch resistance for the TSV-under-test before it is selected;
d) a measurement enable that is common for all of N TSVs - this is used for calibrating the switch resistances of the TSV-under-test before it is selected;
e) a single serial scan data input;
f) a single asynchronous active-low reset that resets the configuration in the boundary scan registers;
g) a single asynchronous active-low reset that resets the parasitic capacitances as well as being used as a short enable switch for the aggressor TSV; and
h) N sense lines where each is connected to each of N TSVs.

The actual pin overhead is substantially lower. Most of signals above could be generated by means of an on-chip test controller accessed by the industry-standard JTAG protocol. Pins required for the JTAG protocol (TDI, TDO, TCLK, TMS, TRST) could well be utilised (Figure 6). The remaining pin overhead will then be limited to the current path pins: ICALSENSE, ISHRSENSE and IFORCE.

The active area and wiring overhead of test circuits are also negligible. As the circuit operates in current mode, the location of the unit cells in the chip can be selected and grouped together to provide a compact layout. It is also possible to integrate the complete group of cells in the digital part of the circuit in order to have a compact routing of control/clock signals in the circuit.

Integrating the TSV test circuits in the digital part, will not jeopardise the industry-standard IDDQ tests (current testing in the quiescent state for CMOS technology). The IDDQ test will be done by keeping the calibration enable, c) above, high and the measurement enable, d) above, low. This ensures no conducting current during IDDQ.

Ideal testing is done by testing leakage of each TSV one by one, by testing short of each TSV to each of TSVs that could act as aggressor, and by measuring the connection of each TSV to the tier below. The worst-case test time for an M-tier system where each tier consists of N TSVs will consist of the following steps:
1) Wafer sort and/or wafer thinning:
   - Step-1: MxN leakage measurements
   - Step-2: Nx(N-1)*M short measurements
2) Stacking and/or final device:
   - Step-1: MxN leakage measurements
   - Step-2: Nx(N-1)*(M-1) short measurements
   - Step-3: N*(M-1) connection measurements where each device is tested negative in step-2

Test time will be significantly reduced by selecting TSVs in parallel to measure the overall leakage of all TSVs. Test time for shorts will be reduced by selecting aggressor TSVs in groups that create a potential short with the TSV-under-test and that are in close proximity to the TSV-under-test. It is also possible to select TSVs in parallel to measure the connection between the tier under test and the bottom tier once any potential short fault within that group is screened negative from the previous short test. Following this optimisation, the overall test time in an M-tier where each tier consists of N TSVs for different stages of testing will consist of following steps:
1) Wafer sort and/or wafer thinning:
   - Step-1: M leakage measurements
   - Step-2: NxM short measurements
2) Stacking and/or final device:
   - Step-1: M leakage measurements
   - Step-2: NxM short measurements
   - Step-3: (M-1) connection measurements where each device is tested negative in step-2

As an example, for a system with 4 tiers where each tier employs 100 TSVs, the parallel leakage test time for 100 TSVs will be 1 ms per tier, and the typical test time for each of the short and connection measurements will be 10µs per TSV. Therefore, for each of wafer-sort and wafer-thinning testing phases, the test time will be 8ms (4ms for leakage + 4ms for short). For each of the stacking and final device testing phases, the test time will be 8.01 ms (4ms for leakage + 4ms short + 0.01 ms for connection). The overall test time for all phases of test will be 32.01 ms, which is considerably short compared to the typical test time of complex chips, for example, between 5s and 10s test time for each of wafer-sort and final test for a chip having more than 100,000 gates with 400 input/outputs).

It will be appreciated that the present invention is not limited to testing TSVs and/or ubumps and can be used to test other components in an IC.

## Claims

1. A method for performing at least one fault mode test on at least one of a plurality of through-silicon-via connections (110, 120; 210, TSV1, TSV2, TSV3, ..., TSVN, 410, 450) arranged on a substrate in an integrated circuit (100; 200; 310, 320, 330), the method comprising the steps of:-
a) selecting a through-silicon-via connection (410) to be tested from said plurality of through-silicon-via connections (110, 120; 210, TSV1, TSV2, TSV3, ..., TSVN; 410, 450);
b) selecting a calibration mode for the selected through-silicon-via connection (410) by activating at least one switch (C1, C2, ..., CN) in a path connecting the selected through-silicon-via connection (410) to a calibration current path (ICALSENSE);
c) determining a calibration current measurement for the selected through-silicon-via connection (410);
d) selecting a measurement mode for the selected through-silicon-via connection (410) by activating at least one switch (T1, T2, ..., TN) in a path connecting the selected through-silicon-via connection (410) to a test current path (IFORCE);
e) determining a measurement current for the selected through-silicon-via connection (410);
f) determining an actual measurement current by comparing the determined calibration current measurement and the determined measurement current in order to cancel out the effects of the resistance of the switches; and
g) comparing the actual measurement current to a threshold in accordance with a screening condition for the selected through-silicon-via connection (410).

2. The method according to claim 1, wherein said at least one fault mode test comprises a leakage test between the selected through-silicon-via connection (410) and the substrate.

3. The method according to claim 1 or 2, wherein said at least one fault mode test comprises a short test between the selected through-silicon-via connection (410) and at least one other through-silicon-via connection (450) in close proximity to the selected through-silicon-via connection (410).

4. The method according to claim 3, wherein steps b) and c) are repeated for said at least one other through-silicon-via connection (450), and step f) comprises using the calibration measurements for the selected through-silicon-via connection (410) and said at least one other through-silicon-via connection (450).

5. The method according to any one of the preceding claims, wherein said at least one fault mode test comprises a connection test between the selected through-silicon-via connection and another tier (310, 320, 330) of the integrated circuit.

6. An on-chip test circuit (200; 300; 400) for performing at least one fault mode test, according to the method of any of the preceding claims, on at least one through-silicon-via connection (110, 120; 210, TSV1, TSV2, TSV3, ..., TSVN; 410, 450) in an integrated circuit, the circuit comprising:-
a power supply (PWR);
a calibration current path (ICALSENSE) connectable to ground and to said at least one through-silicon-via connection (410);
a short current path (ISHRSENSE) connectable to ground and to said at least one through-silicon-via connection (410);
a test current path (IFORCE) connected to the power supply (PWR) and to said at least one through-silicon-via connection (410);
a plurality of switches (C1, C2, ..., CN, A1, A2, ..., AN, T1, T2, ..., TN) for connecting said at least one through-silicon-via connection to at least one of the calibration current path (ICALSENSE), the short current path (ISHRSENSE) and the test current path (IFORCE); and
a controller (230) adapted for selecting said at least one through-silicon-via connection (410) to be tested and for enabling at least one switch (C1, C2, ..., CN, A1, A2, ..., AN, T1, T2, ..., TN) in accordance with said at least one fault mode test.

7. The on-chip test circuit according to claim 6, further comprising a pull-up resistor (420) connected to the test current path (IFORCE) for providing current measurements in accordance with said at least one fault mode test.

8. The on-chip test circuit according to claim 7, wherein the pull-up resistor (420) is formed on the integrated circuit.

9. The on-chip test circuit according to claim 7, wherein the pull-up resistor (420) forms part of the test circuit.

10. The on-chip test circuit according to any one of claims 6 to 9, further comprising first and second pull-down resistors (430, 440) connected between respective ones of the calibration current path (ICALSENSE) and the short current path (ISHRSENSE) and ground (GND).

11. The on-chip test circuit according to any one of claims 6 to 10, wherein said at least one through-silicon-via connection is formed on at least one tier (310, 320, 330) of the integrated circuit.

12. The on-chip test circuit according to claim 11, wherein the integrated circuit comprises a plurality of tiers (310, 320, 330).

## Patentansprüche

1. Verfahren zum Durchführen mindestens eines Fehlermodustests an mindestens einer von mehreren Durchkontaktierung-durch-Silicium-Verbindungen (110, 120; 210, TSV1, TSV2, TSV3, ..., TSVN, 410, 450), die auf einem Substrat angeordnet sind, in einer integrierten Schaltung (100; 200; 310, 320, 330), wobei das Verfahren die folgenden Schritte umfasst:
a) Auswählen einer Durchkontaktierung-durch-Silicium-Verbindung (410), die zu testen ist, aus den mehreren Durchkontaktierung-durch-Silicium-Verbindungen (110, 120; 210, TSV1, TSV2, TSV3, ..., TSVN, 410, 450);
b) Auswählen eines Kalibrierungsmodus für die ausgewählte Durchkontaktierung-durch-Silicium-Verbindung (410) durch Aktivieren mindestens eines Schalters (C1, C2, ..., CN) auf einem Pfad, der die ausgewählte Durchkontaktierung-durch-Silicium-Verbindung (410) mit einem Kalibrierungsstrompfad (ICALSENSE) verbindet;
c) Ermitteln einer Kalibrierungsstrommessung für die ausgewählte Durchkontaktierung-durch-Silicium-Verbindung (410);
d) Auswählen eines Messmodus für die ausgewählte Durchkontaktierung-durch-Silicium-Verbindung (410) durch Aktivieren mindestens eines Schalters (T1, T2, ..., TN) auf einem Pfad, der die ausgewählte Durchkontaktierung-durch-Silicium-Verbindung (410) mit einem Teststrompfad (IFORCE) verbindet;
e) Ermitteln eines Messstroms für die ausgewählte Durchkontaktierung-durch-Silicium-Verbindung (410);
f) Ermitteln eines tatsächlichen Messstroms durch Vergleichen der ermittelten Kalibrierungsstrommessung mit dem ermittelten Messstrom, um die Effekte des Widerstands der Schalter zu eliminieren; und
g) Vergleichen des tatsächlichen Messstroms mit einem Schwellenwert gemäß einer Abtastbedingung für die ausgewählte Durchkontaktierung-durch-Silicium-Verbindung (410).

2. Verfahren nach Anspruch 1, wobei der mindestens eine Fehlermodustest einen Leckstromtest zwischen der ausgewählten Durchkontaktierung-durch-Silicium-Verbindung (410) und dem Substrat umfasst.

3. Verfahren nach Anspruch 1 oder 2, wobei der mindestens eine Fehlermodustest einen Kurzschlusstest zwischen der ausgewählten Durchkontaktierung-durch-Silicium-Verbindung (410) und mindestens einer anderen Durchkontaktierung-durch-Silicium-Verbindung (450) in enger Nachbarschaft zu der ausgewählten Durchkontaktierung-durch-Silicium-Verbindung (410) umfasst.

4. Verfahren nach Anspruch 3, wobei die Schritte b) und c) für die mindestens eine andere Durchkontaktierung-durch-Silicium-Verbindung (450) wiederholt werden und der Schritt f) das Verwenden der Kalibrierungsmessungen für die ausgewählte Durchkontaktierung-durch-Silicium-Verbindung (410) und die mindestens eine andere Durchkontaktierung-durch-Silicium-Verbindung (450) umfasst.

5. Verfahren nach einem der vorhergehenden Ansprüche, wobei der mindestens eine Fehlermodustest einen Verbindungstest zwischen der ausgewählten Durchkontaktierung-durch-Silicium-Verbindung und einer anderen Ebene (310, 320, 330) der integrierten Schaltung umfasst.

6. On-Chip-Testschaltung (200; 300; 400) zum Durchführen mindestens eines Fehlermodustests gemäß dem Verfahren nach einem der vorhergehenden Ansprüche an mindestens einer Durchkontaktierung-durch-Silicium-Verbindung (110, 120; 210, TSV1, TSV2, TSV3, ..., TSVN; 410, 450), in einer integrierten Schaltung, wobei die Schaltung das Folgende umfasst:
eine Spannungsversorgung (PWR);
einen Kalibrierungsstrompfad (ICALSENSE), welcher mit Masse und der mindestens einen Durchkontaktierung-durch-Silicium-Verbindung (410) verbindbar ist;
einen Kurzschlussstrompfad (ISHRSENSE), welcher mit Masse und der mindestens einen Durchkontaktierung-durch-Silicium-Verbindung (410) verbindbar ist;
einen Teststrompfad (IFORCE), welcher mit der Spannungsversorgung (PWR) und der mindestens einen Durchkontaktierung-durch-Silicium-Verbindung (410) verbunden ist;
mehrere Schalter (C1, C2, ..., CN, A1, A2, ..., AN, T1, T2, ..., TN) zum Verbinden der mindestens einen Durchkontaktierung-durch-Silicium-Verbindung mit mindestens einem aus dem Kalibrierungsstrompfad (ICALSENSE), dem Kurzschlussstrompfad (ISHRSENSE) und dem Teststrompfad (IFORCE) und
eine Steuerung (230), welche dafür geeignet ist, die mindestens eine zu testende Durchkontaktierung-durch-Silicium-Verbindung (410) auszuwählen und mindestens einen Schalter (C1, C2, ..., CN, A1, A2, ..., AN, T1, T2, ..., TN) gemäß dem mindestens einen Fehlermodustest einzuschalten.

7. On-Chip-Testschaltung nach Anspruch 6, welche ferner einen Endwiderstand (420), der mit dem Teststrompfad (IFORCE) verbunden ist, zum Bereitstellen von Strommessungen gemäß dem mindestens einen Fehlermodustest umfasst.

8. On-Chip-Testschaltung nach Anspruch 7, wobei der Endwiderstand (420) auf der integrierten Schaltung ausgebildet ist.

9. On-Chip-Testschaltung nach Anspruch 7, wobei der Endwiderstand (420) einen Teil der Testschaltung bildet.

10. On-Chip-Testschaltung nach einem der Ansprüche 6 bis 9, welche ferner erste und zweite Endwiderstände (430, 440) umfasst, die zwischen entsprechenden dem Kalibrierungsstrompfad (ICALSENSE) bzw. dem Kurzschlussstrompfad (ISHRSENSE) und Masse (GND) verbunden sind.

11. On-Chip-Testschaltung nach einem der Ansprüche 6 bis 10, wobei die mindestens eine Durchkontaktierung-durch-Silicium-Verbindung auf mindestens einer Ebene (310, 320, 330) der integrierten Schaltung ausgebildet ist.

12. On-Chip-Testschaltung nach Anspruch 11, wobei die integrierte Schaltung mehrere Ebenen (310, 320, 330) umfasst.

## Revendications

1. Procédé pour effectuer au moins un test en mode de défaillance sur au moins une d'une pluralité de connexions par trous métallisés traversant le silicium (110, 120 ; 210, TSV1, TSV2, TSV3, ..., TSVN, 410, 450) agencées sur un substrat dans un circuit intégré (100 ; 200 ; 310, 320, 330), le procédé comprenant les étapes consistant à :
a) sélectionner une connexion par trou métallisé à travers du silicium (410) à tester parmi ladite pluralité de connexions par trous métallisés traversant le silicium (110, 120; 210, TSV1, TSV2, TSV3, ..., TSVN, 410, 450) ;
b) sélectionner un mode d'étalonnage pour la connexion par trou métallisé traversant le silicium (410) par activation d'au moins un commutateur (C1, C2,..., CN) dans un chemin connectant la connexion par trou métallisé traversant le silicium (410) à un chemin de courant d'étalonnage (ICALSENSE) ;
c) déterminer une mesure du courant d'étalonnage pour la connexion par trou métallisé traversant le silicium (410) ;
d) sélectionner un mode de mesure pour la connexion par trou métallisé traversant le silicium (410) sélectionnée par activation d'au moins un commutateur (T1, T2, ..., TN) dans un chemin connectant la connexion par trou métallisé traversant le silicium (410) sélectionnée à un chemin de courant de test (IFORCE);
e) déterminer un courant de mesure pour la connexion par trou métallisé traversant le silicium (410) sélectionnée ;
f) déterminer un courant de mesure effectif par comparaison de la mesure de courant d'étalonnage déterminée et le courant de mesure déterminé afin d'annuler les effets de la résistance des commutateurs ; et
g) comparer le courant de mesure effectif à un seuil en fonction d'une condition d'examen pour la connexion par trou métallisé traversant le silicium (410).

2. Procédé selon la revendication 1, dans lequel au moins un test en mode de défaillance comprend un test de fuite entre la connexion par trou métallisé traversant le silicium (410) sélectionnée et le substrat.

3. Procédé selon la revendication 1 ou 2, dans lequel au moins un test en mode de défaillance comprend un test de court-circuit entre la connexion par trou métallisé traversant le silicium (410) sélectionnée et au moins une autre connexion par trou métallisé traversant le silicium (450) à proximité immédiate de la connexion par trou métallisé traversant le silicium (410) sélectionnée.

4. Procédé selon la revendication 3, dans lequel les étapes b) et c) sont répétées pour ladite au moins une autre connexion par trou métallisé traversant le silicium (450), et l'étape f) comprend l'utilisation des mesures d'étalonnage pour la connexion par trou métallisé traversant le silicium (410) sélectionnée et ladite au moins une autre connexion par trou métallisé traversant le silicium (450).

5. Procédé selon l'une quelconque des revendications précédentes, dans lequel ledit au moins un test en mode de défaillance comprend un test de connexion entre la connexion par trou métallisé traversant le silicium (410) sélectionnée et une autre couche (310, 320, 330) du circuit intégré.

6. Circuit de test sur puce (200 ; 300 ; 400) pour effectuer au moins un test en mode de défaillance, selon le procédé de l'une quelconque des revendications précédentes, sur au moins une connexion par trou métallisé traversant le silicium (110, 120 ; 210, TSV1, TSV2, TSV3, ..., TSVN, 410, 450) dans un circuit intégré, le circuit comprenant :
une alimentation électrique (PWR) ;
un chemin de courant d'étalonnage (ICALSENSE) pouvant être connecté à la terre et à ladite au moins une connexion par trou métallisé traversant le silicium (410) ;
un chemin de courant de court-circuit (ISHRSENSE) pouvant être connecté à la terre et à ladite au moins une connexion par trou métallisé traversant le silicium (410) ;
un chemin de courant de test (IFORCE) connecté à l'alimentation électrique (PWR) et à ladite au moins une connexion par trou métallisé traversant le silicium (410) ;
une pluralité de commutateurs (C1, C2, ..., CN, A1, A2, ..., AN, T1, T2, ..., TN) pour connecter ladite au moins une connexion par trou métallisé traversant le silicium à au moins un du chemin de courant d'étalonnage (ICALSENSE), du chemin de courant de court-circuit (ISHRSENSE) et du chemin de courant de test (IFORCE) ; et
un contrôleur (230) apte à sélectionner ladite au moins une connexion par trou métallisé traversant le silicium (410) à tester et à activer au moins un commutateur (C1, C2, ..., CN, A1, A2, ..., AN, T1, T2, ..., TN) en conformité avec ledit au moins un test en mode de défaillance.

7. Circuit de test sur puce selon la revendication 6, comprenant en outre une résistance de rappel vers le niveau haut (420) connectée au chemin de courant de test (IFORCE) pour fournir des mesures de courant en conformité avec ledit au moins un test en mode de défaillance.

8. Circuit de test sur puce selon la revendication 7, dans lequel la résistance de rappel vers le niveau haut (420) est formée sur le circuit intégré.

9. Circuit de test sur puce selon la revendication 7, dans lequel la résistance de rappel vers le niveau haut (420) fait partie du circuit de test.

10. Circuit de test sur puce selon l'une quelconque des revendications 6 à 9, comprenant en outre des première et deuxième résistances de rappel vers le niveau bas (430, 440) connectées entre des chemins respectifs du chemin de courant d'étalonnage (ICALSENSE) et du chemin de courant de court-circuit (ISHRSENSE) et la terre (GND).

11. Circuit de test sur puce selon l'une quelconque des revendications 6 à 10, dans lequel ladite au moins connexion par trou métallisé traversant le silicium est formée sur au moins une couche (310, 320, 330) du circuit intégré.

12. Circuit de test sur puce selon la revendication 11, dans lequel le circuit intégré comprend une pluralité de couches (310, 320, 330).
